# EUROPEAN PATENT APPLICATION

(11) **EP 2 500 910 A1**
(43) Date of publication of application: **19.09.2012**
(21) Application number: 11275153.2
(22) Date of filing: 01.12.2011
(51) Int. Cl.: H01B 1/22, H01L 31/0224

(54) **Copper nano paste, method for forming the copper nano paste, and method for forming electrode using the copper nano paste**

(30) Priority: 25.02.2011 KR 20110017200
(71) Applicant: Samsung Electro-Mechanics Co., Ltd, Suwon, Gyunggi-Do (KR)
(72) Inventor: Kim, Dong Hoon, Gyeonggi-do 463-730 (KR); Oh, Sung Il, Seoul 151-774 (KR); Kang, Sung Koo, Gyeonggi-do 443-774 (KR); Jun, Byung Ho, Seoul 153-864 (KR); Song, Young Ah, Gyeonggi-do 441-727 (KR); Kim, Seong Jin, Gyeonggi-do 463-779 (KR); Chun, Byoung Jin, Seoul 157-734 (KR)
(74) Representative: Crowhurst, Charlotte Waveney

(57) **Abstract**

Provided is a copper nano paste that can be calcined at a relatively low temperature. The copper nano paste includes: a binder added in an amount of 0.1 to 30 parts by weight; an additive added in an amount of not more than 10 parts by weight; and copper particles added in an amount of 1 to 95 parts by weight, wherein the copper particles have a particle size of 150 nm or less, and the surfaces of the copper particles are coated with a capping material.

## Description

### CROSS-REFERENCE TO RELATED APPLICATIONS

Claim and incorporate by reference domestic priority application and foreign priority application as follows:

### "CROSS REFERENCE TO RELATED APPLICATION

This application claims the benefit under 35 U.S.C. Section 119 of Korean Patent Application Serial No. 10-2011-0101720, entitled filed February 25, 2011, which is hereby incorporated by reference in its entirety into this application.

### BACKGROUND OF THE INVENTION

### 1. Field of the Invention

The present invention relates to a copper paste, a method for forming the copper paste, and a method for forming an electrode of a solar cell using the copper paste, and more particularly, to a copper nano paste, which can be calcined at a low temperature of 200°C or less, a method for forming the copper nano paste, and a method for forming an electrode of a solar cell using the copper nano paste. In particular, the present invention relates to a copper nano paste, a method for forming the copper nano paste, and a method for forming an electrode using the copper nano paste, in which the copper nano paste can be used to form an electrode on a silicon substrate, a polymer substrate, a glass plate, or a printed circuit board, to which it is difficult to apply a high temperature process, using a screen printing process or the like.

### 2. Description of the Related Art

Silver (Ag) nano paste or gold (Au) nano paste has been widely used for forming electrodes of solar cells. The use of Ag nano paste or Au nano paste, however, may considerably increase manufacturing costs of electrodes. Hence, techniques for forming an electrode of a solar cell using a relatively cheap copper (Cu) nano paste by an inkjet printing process have recently been developed.

A cupper metal is easily oxidized. Therefore, a Cu nano paste having a nano-scale particle size is very easily oxidized as compared to Ag nano paste or Au nano paste. Specifically, since copper is easily oxidized in the atmosphere at a temperature of about 120°C, it is very difficult to form an electrode through a heat treatment. Therefore, the calcination of a copper nanoparticle ink needs to be performed at a reducing atmosphere so as to prevent the oxidation of a copper nano paste. In addition, in order to form an electrode on a substrate for a solar cell using the copper nano paste, the calcination temperature is limited to a glass transition temperature (Tg) of the substrate or less.

To satisfy the above conditions, a copper nano paste may be calcined in a reducing atmosphere using hydrogen gas. In this case, however, a heat treatment needs to be performed for a relatively long period of time in a temperature atmosphere of about 600°C or more in order to complete the calcination of the copper nano paste. Furthermore, a specific resistance of an electrode is very high. If a silicon substrate is used as the substrate for the solar cell, the copper nano paste may not be calcined because the glass transition temperature (Tg) of the silicon substrate is about 250°C or less.

Meanwhile, Ag paste having a particle size of several micrometers has been used. Such a micro-scale Au paste requires a calcination temperature of about 500°C or more. Therefore, in the case of a solar cell having an amorphous silicon layer, there is a limitation in forming an electrode using the Ag paste. To overcome the limitation, a low temperature curable Ag paste may be used. In this case, however, a specific resistance of an electrode is high, which deteriorates electrode properties. In addition, if a current is applied to the electrode formed using the Ag paste for a long period of time, a migration phenomenon occurs. That is, Ag particles are migrated from the electrode to the exterior.

Moreover, a paste composition must be able to be calcined at a temperature of at least 200°C or less in order that an electrode can be formed by a screen printing process on a polymer substrate, a glass plate, and a printed circuit board, to which it is difficult to perform a high temperature process. However, Au, Ag and Cu paste compositions, which are currently being used, have a calcination temperature of 300°C or more. Therefore, it may be difficult to apply these paste compositions to the above-mentioned technical fields.

### SUMMARY OF THE INVENTION

The present invention has been invented in order to overcome the above-described problems and it is, therefore, an object of the present invention to provide a copper nano paste, which can be calcined at a low temperature of about 200°C or less, and a method for forming the same.

It is another object of the present invention to provide a copper nano paste, which can be used to form an electrode on a silicon substrate, a polymer substrate, a glass plate, or a printed circuit board, to which it is difficult to apply a high temperature process, and a method for forming the same.

It is another object of the present invention to provide a copper nano paste, which can be used to form an electrode having a low specific resistance as compared to an electrode formed using Ag paste, and a method for forming the same.

It is another object of the present invention to provide a method for forming an electrode using a copper nano paste, which can be calcined at a low temperature of about 200° C or less.

It is another object of the present invention to provide a method for forming an electrode on a silicon substrate, a polymer substrate, a glass plate, or a printed circuit board, to which it is difficult to apply a high temperature process.

It is another object of the present invention to provide a method for forming an electrode having a low specific resistance as compared to an electrode formed using Ag paste.

In accordance with one aspect of the present invention to achieve the object, there is provided a copper nano paste, which includes: a binder added in an amount of 0.1 to 30 parts by weight; an additive added in an amount of not more than 10 parts by weight; and copper particles added in an amount of 1 to 95 parts by weight, wherein the copper particles have a particle size of 150 nm or less, and the surfaces of the copper particles are coated with a capping material.

The capping material may include at least one of fatty acid and fatty amine.

The binder may include at least one of cellulose-based resin, acryl-based resin, epoxy resin, vinyl-based resin, imide-based resin, amide-based resin, and butyral resin.

The additive may include a thixotropic agent and a leveling agent.

In accordance with another embodiment of the present invention, there is provided a method for forming a copper nano particle, which comprises: forming a mixed solution by supplying a copper compound, a reducing agent, and a solvent to a reactor; adding a capping material to the mixed solution to form a reaction composition with copper nano particles having a particle size of 150 nm or less, wherein the surfaces of the copper nano particles are coated with the capping material; and obtaining the copper nano particles from the reaction composition.

At least one of fatty acid and fatty amine may be used as the capping material.

The step of forming the mixed solution may include adding at least one of cellulose-based resin, acryl-based resin, epoxy resin, vinyl-based resin, imide-based resin, amide-based resin, and butyral resin to the mixed solution.

The step of forming the mixed solution may include adding a thixotropic agent and a leveling agent to the mixed solution.

The method may further include adding at least one of a thixotropic agent and a leveling agent to the reaction composition.

The step of forming the mixed solution may include: injecting terpineol into the reactor; dissolving ethyl cellulose in the terpineol; and adding copper nano particles having a particle size of 10 nm or less while lowering a temperature applied to the reactor.

The step of forming the mixed solution may include: injecting terpineol into the reactor; dissolving toluene, ethyl cellulose, cellulose acetate derivatives, and methyl methacrylate polymer into the terpineol; and adding copper nano particles having a particle size of 10 nm or less while lowering a temperature applied to the reactor.

The step of forming the mixed solution may include: injecting butyl carbitol into the reactor; and adding copper nano particles while dissolving hydroxypropyl methylcellulose and ethyl methacrylic acid polymer in the butyl carbitol.

The step of forming the mixed solution may include: mixing terpineol, dihydroterpineol, and neodecanate in the reactor; and dissolving ethyl cellulose, butyl methacrylate, and ethyl methacrylic acid polymer in the reactor while lowering a temperature applied to the reactor.

The step of forming the mixed solution may include: injecting terpineol into the reactor; dissolving butyl carbitol, cellulose acetate, and hydroxy propyl cellulose in the terpineol; and adding dioctyl phthalate and a surfactant to the reactor.

In accordance with another embodiment of the present invention, there is provided a method for forming an electrode using the above-described copper nano paste, which includes: preparing a substrate for forming an electrode; coating the copper nano paste on the substrate; and calcining the copper nano paste at a temperature of 200°C.

The step of preparing the substrate may include preparing a substrate for a solar cell, in which a transparent conductive oxide is deposited, and the step of coating the copper nano paste may include printing the copper nano paste on the substrate for the solar cell using a screen printing process.

The step of preparing of the substrate may include preparing a polyimide substrate for a printed circuit board, and the step of coating the copper nano paste may include coating the copper nano paste on a polyimide substrate using a screen printing process. The step of calcining the copper nano paste may include reduction-calcining the copper nano paste under a temperature atmosphere of 180°C.

The step of preparing the substrate may include preparing any one of a silicon substrate, a polymer substrate, a glass plate, and a printed circuit board.

### DETAILED DESCRIPTION OF THE PREFERABLE EMBODIMENTS

The objects, features, and advantages of the present invention will be apparent from the following detailed description of embodiments of the invention. The present invention may, however, be embodied in different forms and should not be construed as limited to the embodiments set forth herein. Rather, these embodiments are provided so that this disclosure will be thorough and complete, and will fully convey the scope of the present invention to those skilled in the art.

The terms used herein are merely used to describe particular embodiments and are not intended to limit the present invention. An expression used in the singular encompasses the expression of the plural, unless it has a clearly different meaning in the context. In the present application, it should be understood that the terms such as "including" or "having," etc., are intended to indicate the existence of the components, steps, operations and/or devices disclosed in the specification, and are not intended to preclude the possibility that one or more other components, steps, operations and/or devices may exist or may be added.

Hereinafter, a copper nano paste, a method for forming the same, and a method for forming an electrode using the same in accordance with embodiments of the present invention will be described.

A copper nano paste in accordance with an embodiment of the present invention may be a material for forming a predetermined metal pattern. For example, the copper nano paste may be a material for forming an electrode of a solar cell. The copper nano paste may include copper particles having a nano-scale particle size. For example, the diameter of each copper particle may be about 150 nm or less. More preferably, the diameter of each copper particle may be about 20 nm or less. The decrease in the diameter of the copper particle may improve a coating property of the copper paste and an electrical property of a conductive pattern formed using the copper paste. To be specific, as the diameter of the copper particle decreases, heat reactivity is improved and therefore calcination efficiency is improved.

The copper particles may be coated with a predetermined capping material. The capping material may be used as a dispersing agent for preventing the copper particles of the copper nano paste from being aggregated. To this end, a step of capping the copper particles with the capping material may be added to a step of synthesizing the copper particles.

Various kinds of materials may be used as the capping material. For example, various kinds of fatty acids may be used as the capping material. The copper nano particles capped with the capping materials may be prepared using various preparing methods, whose patent applications were filed by the applicant of the present invention. As one example, according to Korean Patent Application No. 2005-72478, metal nano particles can be capped with fatty acid such alkanoic acid, for example, lauric acid, oleic acid, decanoic acid, and palmitic acid, using a copper compound acting as a reducing agent. As another example, according to Korean Patent Application No. 2005-66936, fatty acid can be capped around metal nano particles by performing a heat treatment on metal alkanoate. As another example, according to Korean Patent Application No. 2006-64481, a metal precursor is dissociated in fatty acid, and metal nano particles are capped with fatty acid using metallic salts of metal such as tin, magnesium, and iron. As another example, according to Korean Patent Application No. 2006-98315, copper nano particles capped with fatty acid can be obtained by dissociating a copper precursor material in fatty acid and heating the copper precursor material, or by further adding a reducing agent. As another example, metal nano particles capped with fatty amine can be used. In this case, as disclosed in Korean Patent Application No. 2006-127697, particles having two dispersing agents, that is, fatty acid and fatty amine, at the same time may be used. The above-described methods are merely exemplary rather than limited thereto. Also, various methods may be used for preparing the metal nano particles capped with fatty acid.

In addition, the copper nano paste may further include a binder and other additives. The binder and other additives will be described below in more detail.

An electrode of a solar cell may be formed using the above-described copper paste. For example, a method for forming an electrode of a solar cell in accordance with an embodiment of the present invention may include printing a copper nano paste on a substrate for a solar cell, and calcining the printed copper nano paste.

Hereinafter, a copper nano paste, a method for forming the same, and a method for forming an electrode of a solar cell using the same, in accordance with specific embodiments of the present invention, will be described. The preparing methods, which will be described below, are merely exemplary, and the spirit and scope of the present invention are not limited thereto.

<Preparing Method>

a) Formation of Copper Nano Particles

A method for forming a copper nano particle in accordance with an embodiment of the present invention may include forming a metal precursor including copper (Cu), reducing the metal precursor under a high temperature atmosphere, and capping the surface of the metal precursor with a predetermined capping material.

A mixed solution may be prepared by supplying a copper-containing compound, a first reducing agent, and a solvent to a reactor. The step of preparing the mixed solution may be performed in a temperature range of 30°C to 250°C.

A capping material having the same mole number as the copper compound may be gradually dropped into the mixed solution within the reactor in order to control the particle size of copper nano particles and stabilize the copper nano particles. Various kinds of fatty acids and fatty amines may be used as the capping material.

In addition, a second reducing agent may be added to the mixed solution, so that the mixed solution is reacted at a relatively high temperature. At least one of ascorbic acid, phenolic acid, maleic acid, acetic acid, citric acid, and formic acid may be used as the first and second reducing agents.

Through the above processes, a reaction composition including copper nano particles having a substantially spherical shape with a diameter of 150 nm or less may be formed within the reactor.

Thereafter, a post-treatment process may be performed to obtain the copper nano particles from the reaction composition. For example, the post-treatment process may include cooling the composition with a reaction solvent, cleaning the composition with a non-solvent, and centrifuging the composition. At this time, the post-treatment process may be repeated in order to obtain more uniform copper nano particles with high purity. Therefore, the copper nano particles having a diameter of 150 nm or less may be prepared from the reaction composition. At this time, it is preferable that the copper nano particles have a diameter of 20 nm or less.

As described above, the method for forming the copper nano particles in accordance with the embodiment of the present invention may form the copper nano particles, the surfaces of which are capped with the capping material. When a copper nano paste will be formed in a subsequent process, the capping material may prevent the aggregation of the copper nano particles.

b) Formation of Copper Nano Paste

A copper nano paste in accordance with an embodiment of the present invention may include the copper nano particles prepared by the above-described method, a binder, and an additive.

The copper nano particles may be included in an amount of 1 to 95 parts by weight. If the copper nano particles are added in an amount of not more than 1 part by weight, the content of the copper nano particles is relatively very low. Therefore, if a metal pattern is formed using this copper nano particles, electrical conductivity is low. Consequently, it may be difficult to use the metal pattern as a conductive pattern such as an electrode of a solar cell. On the other hand, if the copper nano particles are added in an amount of not less than 95 parts by weight, the efficiency of mixing with the binder and the solvent may be lowered and the coating efficiency of an inkjet printer may be lowered. Therefore, the copper nano paste is unsuitable as a paste composition for an inkjet printing.

When the copper nano particles are printed, the binder may be applied as a matrix to allow metals and other additive components to form a uniform film on an object to be printed. A resin-based material may be used as the binder. Example of the binder may include at least one of a cellulose-based resin, an acryl-based resin, an epoxy resin, a vinyl-based resin, an imide-based resin, an amide-based resin, and a butyral resin.

The binder may be included in an amount of about 0.1 to 30 parts by weight. If the binder is added in amount of not more than 0.1 parts by weight, the copper nano particles may be difficult to apply on the object to be printed. In addition, the adhesive strength of the copper nano paste with respect to the object to be printed is lowered. Therefore, if an electrode is formed using the copper nano paste on the object to be printed, the adhesive strength between the electrode and the object to be printed is lowere3d. Consequently, the electrode may be easily delaminated from the object to be printed. On the other hand, if the binder is added in an amount of not less than 30 parts by weight, the calcination between the copper nano particles is very difficult. Hence, if an electrode is formed using this copper nano paste, the electrical property of the electrode may be deteriorated.

The additive may include materials for improving the coating property of the copper paste and the property of the electrode. For example, a thixotropic agent and a leveling agent may be included as the additive.

The thixotropic agent may be used to increase mesh transmission efficiency by rapidly decreasing the viscosity of the copper paste in the early stage of the screen printing and to maximally suppress a spread-out of the printed pattern by rapidly increasing the viscosity of the copper paste in the latter stage of the screen printing. To this end, the thixotropic agent may increase the molecular weight of the binder, so that a molecular chain of the binder is arranged in a single direction under a high shear stress. Thus, the viscosity of the copper paste may be decreased in the early stage of the screen printing. In addition, the thixotropic agent may be weakly bonded with the capping material surrounding the copper nano particles.

The leveling agent may prevent the formation of non-uniformed patterns, in which mesh marks remain on the object to be printed, which is caused by the deterioration in the leveling property of the copper paste due to the dispersing agent. To this end, the leveling agent may provide a proper fluidity to the copper paste.

In addition, various types of additives may be used. In this case, the additives may be preferably added in an amount of not more than 10 parts by weight. If the additives are added in an amount of more than 10 parts by weight, the unique property of the additives may be deteriorated, and thus, the electrical property of the electrode formed using the copper paste may be deteriorated.

A material having excellent compatibility with the copper nano particles, the binder, and the additives and having a low boiling point may be used as the solvent in order to prevent the physical property of the paste from being changed by volatility during the manufacturing and printing processes of the copper paste. As one example, the solvent may include at least one organic solvent selected from toluene, methylethylketone, and methylisobutylketone. As another example, the solvent may include at least one non-polar solvent selected from paranyl oil, tetradecane, tetralin, and mineral oil. As another example, the solvent may include at least one polar solvent selected from propyl alcohol, isopropyl alcohol, terpineol, butyl carbitol, and neodecanate.

The mixture of the copper nano particles, the binder, the additives, and the solvent may be mixed by a mixer. A high-speed mixer and a planetary mixer may be used as the mixer. At this time, the mixture may be mixed using a triple roller mill in order to re-dispersing the re-aggregated particles of the mixture. Accordingly, a copper nano paste having a uniform composition may be prepared.

c) Formation of Electrode of Solar Cell

The copper nano paste prepared by the above-described method may be formed on a substrate for a solar cell. For example, the copper nano paste may be printed on a silicon substrate for the solar cell by a screen printing process. In addition, an electrode may be formed on the silicon substrate by calcining the copper nano paste at a temperature of 200°C or less. The electrode may be plus and minus electrodes of the solar cell.

A relatively high temperature processing atmosphere of about 600°C or more is required to calcine a general copper paste. However, if the calcining process is performed under the high temperature processing atmosphere, copper components are easily diffused into the substrate for the solar cell because of their properties. Therefore, a PN junction layer formed in the substrate may be broken down, leading to a reduction in the efficiency of the solar cell. In particular, since a transparent conductive oxide (TCO) layer is deposited on the substrate for the solar cell, the TCO layer is damaged when it is exposed to a high temperature process of 600°C or more. As a result, the efficiency of the solar cell may be lowered.

However, in the case of the copper nano paste in accordance with the embodiment of the present invention, the reactivity of the paste composition is extremely increased by adjusting the size of copper in ulra-fine unit of 150 nm or less. Thus, the copper nano paste may be easily calcined even at a low temperature of 200°C or less. Accordingly, the copper nano paste in accordance with the embodiment of the present invention may be used to form the electrode by a low temperature calcining process on the substrate for the solar cell, in which a thin film damaged at a high temperature atmosphere, such as TCO, is formed.

As described above, the copper nano paste in accordance with the embodiment of the present invention has the composition with high heat reaction efficiency by controlling the size of copper particles to 150 nm or less, and the copper nano paste may be calcined at a low temperature of 200°C or less. Therefore, the copper nano paste may be used as a paste for forming the electrode of the solar cell.

<Examples of Formation of Copper Nano Paste>

a) Example 1

2 g of ethyl cellulose was added to 41 g of terpineol in a reactor and dissolved by heating at a temperature of about 60°C. When the ethyl cellulose was dissolved, 220 g of the copper nano particles having a particle size of 10 nm or less was slowly added, while the temperature applied to the reactor was lowered to about room temperature. Then, a copper nano paste having a viscosity of 5,500 cP was formed by passing the copper nano particles through a triple roller mill.

b) Example 2

10 g of toluene, 1 g of ethyl cellulose, 1 g of cellulose acetate derivatives, and 0.7 g of methyl methacrylate polymer were dissolved by heating at a temperature of about 50°C and mixed with 50 g of terpineol in a reactor. When the ethyl cellulose was dissolved, 170 g of copper nano particles having a particle size of 10 nm or less were slowly added, while the temperature applied to the reactor was lowered to about room temperature. A copper nano paste having a viscosity of 4,000 cP was formed by mixing the copper nano particles using a high speed mixer and passing them through a triple roller mill.

c) Example 3

2.5 g of hydroxypropyl methylcellulose and 1 g of ethyl methacrylic acid polymer were completely dissolved by heating at a temperature of 60°C and mixed with 100 g of butyl carbitol in a reactor. During this process, 250 g of copper nano particles having a particle size of 10 nm or less were slowly added and dissolved. 5 g of aerosil may be further added to give thixotropy. Then, a copper nano paste having a viscosity of 5,000 cP was formed by mixing the copper nano particles using a high speed mixer and passing them through a triple roller mill.

d) Example 4

150 g of terpineol, 10 g of dihydro terpineol, 20 g of neodecanate, 3 g of ethyl cellulose, 3 g of butyl methacrylate, and 3 g of ethyl methacrylic acid copolymer were slowly dissolved in a reactor by heating at a temperature of about 60°C. 325 g of copper nano particles having a particle size of 10 nm or less was slowly added to the mixture within the reactor and dissolved. Then, a copper nano paste having a viscosity of 5,000 cP was formed by mixing the copper nano particles using a high speed mixer and passing them through a triple roller mill.

e) Example 5

40 g of terpineol, 100 g of butyl carbitol, 1 g of cellulose acetate, and 1 g of hydroxy propyl cellulose were slowly dissolved in a reactor by heating at a temperature of about 60°C. 137 g of copper nano particles having a particle size of 10 nm or less was slowly added to the mixture within the reactor and dissolved. 1 g of dioctyl phthalate and 0.5 g of silicon-based surfactant were added in order to improve the thixotropy and surface property. Then, a copper nano paste having a viscosity of 6,000 cP was formed through a triple roller mill.

<Example of Forming Electrode of Solar Cell>

The copper nano paste formed by Examples 1 to 5 as described above was printed on a substrate for a solar cell, on which TCO was deposited, by a screen printing process. Then, the copper nano paste was reduction-calcined under a temperature atmosphere of about 200°C for about 30 minutes to form an electrode pattern having a line width of 100µm.. The electrode pattern had a resistance property of 50 to 200 Ω/m, a contact resistance of 1 to 40 mΩ/cm², and a specific resistance of 3 to 100 uΩ/cm.

Since the copper nano pastes in accordance with Examples of the present invention include copper particles having a particle size of about 150 nm or less, the calcination efficiency thereof is increased. The copper nano pastes can be calcined under a low temperature atmosphere of about 200°C or less. Therefore, the copper nano pastes can be used to form the electrode of the solar cell.

<Example for Forming Electrode of Printed Circuit Board>

The copper nano paste formed by Examples 1 to 5 as described above was printed on a polyimide substrate by a screen printing process. Then, the copper nano paste was reduction-calcined under a temperature atmosphere of about 180°C for about 1 hour to form an electrode pattern having a line width of 80 µm. The electrode pattern had a resistance property of 50 to 200 Ω/m and a specific resistance of 3 to 100 uΩ/cm.

The copper nano paste in accordance with the present invention includes copper nano particles having a particle size of 150 nm or less, and the copper nano particles having high reactivity even at low temperature of 200°C or less are closely contacted and solidified. Therefore, the copper nano paste can be calcined. The copper nano paste can be used to form an electrode on a silicon substrate, a polymer substrate, a glass plate, or a printed circuit board, to which it is difficult to apply a high temperature process.

The method for forming a copper nano paste in accordance with the present invention can form a copper nano paste that can be calcined at low temperature of 200°C or less and used to form an electrode on a silicon substrate, a polymer substrate, a glass plate, or a printed circuit board, to which it is difficult to apply a high temperature process.

The method for forming an electrode in accordance with the present invention can form an electrode on a silicon substrate, a polymer substrate, a glass plate, or a printed circuit board, to which it is difficult to apply a high temperature process, by using a copper nano paste that can be calcined at low temperature of 200°C. Therefore, it is possible to prevent physical and chemical change and damage of materials constituting the substrate in which the electrode is to be formed.

The detailed description is illustrated for the present invention. And also, the context as mentioned above is only for showing and describing preferable embodiments of the present invention, but the present invention can be used at various other combinations, alternations and environments. That is, as described above, although the preferable embodiments of the present invention have been shown and described, it will be appreciated by those skilled in the art that substitutions, modifications and variations may be made in these embodiments without departing from the principles and spirit of the general inventive concept, the scope of which is defined in the appended claims and their equivalents. Therefore, the detailed description of the present invention is not intended to limit the present invention to the disclosed embodiments. In addition, the appended claims should be understood to include other embodiments.

## Claims

1. A copper nano paste, which comprises:
a binder added in an amount of 0.1 to 30 parts by weight;
an additive added in an amount of not more than 10 parts by weight; and
copper particles added in an amount of 1 to 95 parts by weight, wherein the copper particles have a particle size of 150 nm or less, and the surfaces of the copper particles are coated with a capping material.

2. The copper nano paste according to claim 1, wherein the capping material comprises at least one of fatty acid and fatty amine.

3. The copper nano paste according to claim 1 or 2, wherein the binder comprises at least one of cellulose-based resin, acryl-based resin, epoxy resin, vinyl-based resin, imide-based resin, amide-based resin, and butyral resin.

4. The copper nano paste according to any one of the preceding claims, wherein the additive comprises a thixotropic agent and a leveling agent.

5. A method for forming a copper nano particle, which comprises:
forming a mixed solution by supplying a copper compound, a reducing agent, and
a solvent to a reactor;
adding a capping material to the mixed solution to form a reaction composition with copper nano particles having a particle size of 150 nm or less, wherein the surfaces of the copper nano particles are coated with the capping material; and
obtaining the copper nano particles from the reaction composition.

6. The method for forming a copper nano particle according to claim 5, wherein at least one of fatty acid and fatty amine is used as the capping material.

7. The method for forming a copper nano particle according to claim 5 or 6, wherein forming the mixed solution comprises adding at least one of cellulose-based resin, acryl-based resin, epoxy resin, vinyl-based resin, imide-based resin, amide-based resin, and butyral resin to the mixed solution.

8. The method for forming a copper nano particle according to any one of claims 5 to 7, wherein forming the mixed solution comprises adding a thixotropic agent and a leveling agent to the mixed solution.

9. The method for forming a copper nano particle according to any one of claims 5 to 7, which further comprises adding at least one of a thixotropic agent and a leveling agent to the reaction composition.

10. The method for forming a copper nano particle according to any one of claims 5 to 9, wherein forming the mixed solution comprises:
injecting terpineol into the reactor;
dissolving ethyl cellulose in the terpineol; and
adding copper nano particles having a particle size of 10 nm or less while lowering a temperature applied to the reactor.

11. The method for forming a copper nano particle according to any one of claims 5 to 9, wherein forming the mixed solution comprises:
injecting terpineol into the reactor;
dissolving toluene, ethyl cellulose, cellulose acetate derivatives, and
methyl methacrylate polymer into the terpineol; and
adding copper nano particles having a particle size of 10 nm or less while lowering a temperature applied to the reactor.

12. The method for forming a copper nano particle according to any one of claims 5 to 9, wherein forming the mixed solution comprises:
injecting butyl carbitol into the reactor; and
adding copper nano particles while dissolving hydroxypropyl methylcellulose and
ethyl methacrylic acid polymer in the butyl carbitol.

13. The method for forming a copper nano particle according to any one of claims 5 to 9, wherein forming the mixed solution comprises:
mixing terpineol, dihydroterpineol, and neodecanate in the reactor; and
dissolving ethyl cellulose, butyl methacrylate, and ethyl methacrylic acid polymer in the reactor while lowering a temperature applied to the reactor.

14. The method for forming a copper nano particle according to any one of claims 5 to 9, wherein forming the mixed solution comprises:
injecting terpineol into the reactor;
dissolving butyl carbitol, cellulose acetate, and hydroxy propyl cellulose in the terpineol; and
adding dioctyl phthalate and a surfactant to the reactor.

15. A method for forming an electrode using the copper nano paste of any one of claims 1 to 4, which comprises:
preparing a substrate for forming an electrode;
coating the copper nano paste on the substrate; and
calcining the copper nano paste at a temperature of 200°C.

16. The method for forming an electrode according to claim 15, wherein,
preparing the substrate comprises preparing a substrate for a solar cell, in which a transparent conductive oxide is deposited, and
coating the copper nano paste comprises printing the copper nano paste on the substrate for the solar cell using a screen printing process.

17. The method for forming an electrode according to claim 15, wherein,
preparing of the substrate comprises preparing a polyimide substrate for a printed circuit board,
coating the copper nano paste comprises coating the copper nano paste on a polyimide substrate using a screen printing process, and
calcining the copper nano paste comprises reduction-calcining the copper nano paste under a temperature atmosphere of 180°C.

18. The method for forming an electrode according to claim 15, wherein preparing the substrate comprises preparing any one of a silicon substrate, a polymer substrate, a glass plate, and a printed circuit board.
